# EUROPEAN PATENT APPLICATION

(11) **EP 4 770 298 A1**
(43) Date of publication of application: **01.07.2026**
(21) Application number: 24845193.2
(22) Date of filing: 29.05.2024
(51) Int. Cl.: H05K 9/00, H01F 1/28

(54) **ELECTROMAGNETIC WAVE ABSORPTION SHEET AND METHOD FOR MANUFACTURING SAME**

(30) Priority: 27.07.2023 JP 2023122621
(71) Applicant: Maxell, Ltd., Kyoto 618-8525 (JP)
(72) Inventor: TERASAWA Makoto, Kyoto 618-8525 (JP); MIZUTANI Takuo, Kyoto 618-8525 (JP); HIROI Toshio, Kyoto 618-8525 (JP)
(74) Representative: Mewburn Ellis LLP
(86) International application number: PCT/JP2024/019676
(87) International publication number: WO 2025/022811

(57) **Abstract**

An electromagnetic-wave absorbing sheet according to this application includes: a base; and a magnetic layer. The magnetic layer contains a magnetic material and a binder, the magnetic material contains flat carbonyl iron, and the full width at half maximum at the peak of the (200) plane of α iron detected by powder X-ray diffraction for the magnetic layer is 0.15 or more and less than 0.40. A method for manufacturing an electromagnetic-wave absorbing sheet according to the present application includes: a step of subjecting carbonyl iron to reduction treatment; a step of subjecting the reduced carbonyl iron that has been subjected to the reduction treatment to flattening treatment; a step of producing a coating material for forming a magnetic layer by mixing the reduced carbonyl iron that has been subjected to the flattening treatment, a binder, and a solvent together; and a step of applying the coating material for forming a magnetic layer to a base and drying the coating material.

## Description

### Technical Field

The present application relates to an electromagnetic-wave absorbing sheet that absorbs electromagnetic waves in the microwave band to the millimeter-wave band in the near field.

### Background Art

With the development of wireless communication technology typified by mobile phones, various devices and sensors are becoming connected to networks wirelessly. Also, in the medical field, from the viewpoint of preventing infection, devices are increasingly becoming cordless, and medical devices are beginning to be connected wirelessly. These communications require high speed and a large capacity over relatively short distances, and use high frequencies. As the number of devices using such high frequencies increases, there is an increasing risk that failure will occur in electronic devices and communication due to malfunction caused by electromagnetic-wave noise generated from the devices or interference with the electromagnetic waves being used. Furthermore, in recent years, millimeter wave radar has begun to be installed for the purpose of preventing automobile collisions. Failure in these devices in the medical and automotive fields has an impact on human life, and therefore malfunctions must not occur. In view of this, it is increasingly necessary to apply electromagnetic-wave absorbing sheets to circuit elements and transmission lines that emit and receive electromagnetic waves in the microwave band to the millimeter-wave band as a so-called EMC (Electromagnetic Compatibility) countermeasure to prevent failure caused by electromagnetic-wave noise from devices and interference caused by the noise.

In response to an increase in the speed and capacity of mobile communication systems in recent years, the expansion of fifth-generation mobile communication systems (5G) and local 5G has been promoted. The frequency bands used for 5G are the Sub-6 band (3.7 GHz, 4.5 GHz band) and the millimeter-wave band (28 GHz). In response to a technological trend toward use of electromagnetic waves with such higher frequency, there is a growing demand for electromagnetic-wave absorbers and electromagnetic-wave absorbing sheets that absorb unnecessary electromagnetic waves and suppress electromagnetic-wave noise in higher frequency bands.

Under such circumstances, Patent Document 1 proposes a near-field noise suppression sheet, in which the full width at half maximum at a peak of the bcc (200) plane of Fe detected by powder X-ray diffraction is 0.4 or more and an imaginary part µ" of permeability at 10 GHz is 2.0 or more.

### Prior Art Documents

Patent Document

[Patent Document 1] JP 2022-150016A (Japanese Patent No. 7209761)

### Disclosure of Invention

### Problem to be Solved by the Invention

However, the evaluation disclosed in Patent Document 1 is the result of evaluating the imaginary part µ" of permeability at 10 GHz, and does not confirm a high noise suppression effect in the 28 GHz millimeter-wave band used in 5G. In addition, the full width at half maximum at the peak of the bcc (200) plane of Fe detected by powder X-ray diffraction varies depending on whether or not carbonyl iron has been subjected to reduction treatment and the degree of flattening. Non-reduced carbonyl iron has a smaller crystallite size and poorer flattening processability than reduced carbonyl iron, and thus it is not possible to increase the crystalline magnetic anisotropy, and it is not possible to improve a noise suppression effect in the 28 GHz millimeter-wave band, even when the full width at half maximum at the peak of the bcc (200) plane of Fe is 0.4 or more.

The present application solves the above problems and provides an electromagnetic-wave absorbing sheet that can be used by being applied to an uneven or curved surface of an electronic device that requires protection from an influence of electromagnetic-wave noise and that has an electromagnetic-wave absorbing capacity in the microwave band to the millimeter-wave band in the near field.

### Means for Solving Problem

The electromagnetic-wave absorbing sheet according to this application is an electromagnetic-wave absorbing sheet including: a base; and a magnetic layer. The magnetic layer contains a magnetic material and a binder, the magnetic material contains flat carbonyl iron, and the full width at half maximum at the peak of the (200) plane of α iron detected by powder X-ray diffraction for the magnetic layer is 0.15 or more and less than 0.40.

A method for manufacturing an electromagnetic-wave absorbing sheet according to the present application is a method for manufacturing the electromagnetic-wave absorbing sheet according to the present application, the method including: a step of subjecting carbonyl iron to reduction treatment; a step of subjecting the reduced carbonyl iron that has been subjected to the reduction treatment to flattening treatment; a step of producing a coating material for forming a magnetic layer by mixing the reduced carbonyl iron that has been subjected to the flattening treatment, a binder, and a solvent together; and a step of applying the coating material for forming a magnetic layer to a base and drying the coating material.

### Effects of the Invention

According to the present application, it is possible to provide an electromagnetic-wave absorbing sheet that can be used by being applied to an uneven or curved surface of an electronic device that requires protection from an influence of electromagnetic-wave noise and that has an electromagnetic-wave absorbing capacity (noise suppression effect) in the microwave band to the millimeter-wave band in the near field.

### Brief Description of Drawings

[FIG. 1] FIG. 1 is a schematic cross-sectional view showing an example of an electromagnetic-wave absorbing sheet according to an embodiment.
[FIG. 2] FIG. 2 is a schematic cross-sectional view showing another example of the electromagnetic-wave absorbing sheet according to an embodiment.

### Description of the Invention

### (Electromagnetic-wave absorbing sheet)

An embodiment of an electromagnetic-wave absorbing sheet according to the present application will be described. The electromagnetic-wave absorbing sheet according to this embodiment includes: a base; and a magnetic layer, wherein the magnetic layer contains a magnetic material and a binder, the magnetic material contains flat carbonyl iron, and the full width at half maximum at the peak of the (200) plane of α iron detected by powder X-ray diffraction for the magnetic layer is 0.15 or more and less than 0.40.

In the electromagnetic-wave absorbing sheet according to this application, the magnetic layer contains flat carbonyl iron as the magnetic material, and the full width at half maximum at the peak of the (200) plane of α iron detected by powder X-ray diffraction for the magnetic layer is 0.15 or more and less than 0.40. Therefore, the electromagnetic-wave absorbing sheet has high electromagnetic-wave absorbing capacity in the microwave band to the millimeter-wave band, and can have a high noise suppression effect, in particular, in the 28 GHz millimeter-wave band used in 5G. More specifically, it is possible to provide an electromagnetic-wave absorbing sheet having a high transmission attenuation power ratio of 10 dB or more in the 28 GHz millimeter-wave band.

Note that in the present application, the "millimeter-wave band" is defined to include the 28.2 to 29.1 GHz band that can be used for local 5G.

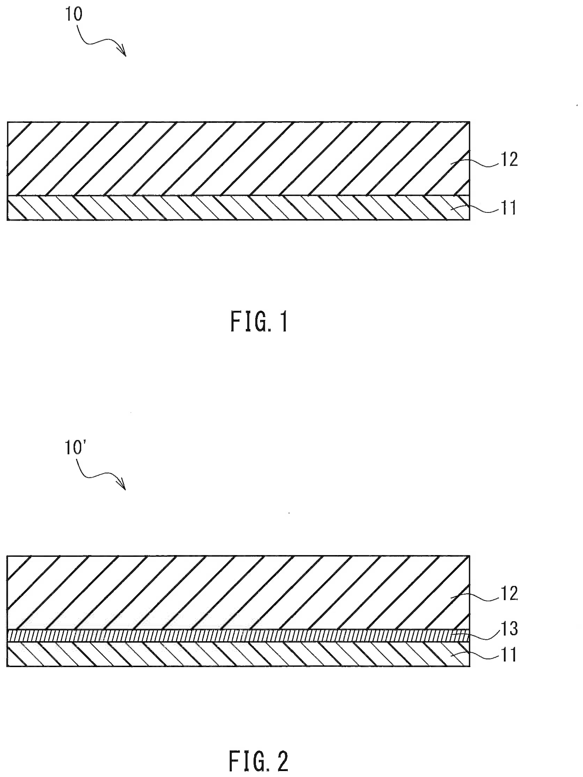

Hereinafter, an electromagnetic-wave absorbing sheet according to this embodiment will be described with reference to the drawings. FIG. 1 is a schematic cross-sectional view showing an example of the electromagnetic-wave absorber according to this embodiment. In FIG. 1, an electromagnetic-wave absorbing sheet 10 includes a base 11 and a magnetic layer 12 disposed on the base 11. Although the electromagnetic-wave absorbing sheet 10 has a two-layer structure consisting of the base 11 and the magnetic layer 12 in FIG. 1, the electromagnetic-wave absorbing sheet 10 may have a three-layer structure by further disposing an adhesive layer on the magnetic layer 12 side.

FIG. 2 is a schematic cross-sectional view showing another example of the electromagnetic-wave absorbing sheet according to this embodiment. In FIG. 2, an electromagnetic-wave absorbing sheet 10' includes a base 11, a metal layer 13 disposed on the base 11, and a magnetic layer 12 disposed on the metal layer 13. Although the electromagnetic-wave absorbing sheet 10' has a three-layer structure consisting of the base 11, the magnetic layer 12, and the metal layer 13 in FIG. 2, the electromagnetic-wave absorbing sheet 10' may have a four-layer structure by further disposing an adhesive layer on the magnetic layer 12 side.

An overall thickness of the electromagnetic-wave absorbing sheet according to this embodiment is not particularly limited, may be 20 to 1000 µm, and is more preferably 20 to 100 µm. This is because if the overall thickness of the electromagnetic-wave absorbing sheet is too small, the magnetic layer will also be thin, an electromagnetic-wave absorbing property will deteriorate, and the strength of the entire sheet will also decrease. This is also because if the overall thickness of the electromagnetic-wave absorbing sheet is too large, the flexibility will decrease, making it difficult to use the sheet by applying the sheet to an uneven or curved surface of an electronic device.

Next, constituent members of the electromagnetic-wave absorbing sheet according to this embodiment will be described.

### <Base>

The base used for the electromagnetic-wave absorbing sheet according to this embodiment is a base body for forming the magnetic layer.

The base may be any base as long as it has flexibility and can ensure adhesion to the magnetic layer, and a resin film is usually used as the base. Examples of the resin forming the base include polyolefin-based resins (such as polyethylene and polypropylene) and polyester resins (such as polyethylene terephthalate: PET, polyethylene naphthalate: PEN, polybutylene terephthalate: PBT, and polybutylene naphthalate: PBN), polyimide-based resins, polyamide-based resins, ethylene-vinyl acetate copolymers, ionomer-based resins, ethylene-(meth)acrylic acid copolymers, ethylene-(meth)acrylic acid ester copolymers, ethylene-butene copolymers, ethylene-hexene copolymers, polyurethane-based resins, polyetherketone-based resins, polyether-based resins, polyethersulfone-based resins, polystyrene-based resins (such as polystyrene), polyvinyl chloride-based resins, polyvinylidene chloride-based resins, polyvinyl alcohol-based resins, polyvinyl acetate-based resins, vinyl chloride-vinyl acetate copolymers, polycarbonate-based resins, fluorine-based resins, silicone-based resins, and cellulose-based resins, and examples of the base include any base made of crosslinked bodies of these resins. In particular, polyethylene terephthalate (PET) is more preferable in terms of mechanical characteristics and cost. One, or two or more of these resin materials can be used. In addition, the above resin material may, if necessary, have a functional group. A functional monomer or a modifying monomer may be grafted onto the resin material.

The surface of the base may be subjected to a known surface treatment to improve adhesion to the adjacent magnetic layer. Specifically, examples of the surface treatment include corona discharge treatment, ozone exposure treatment, high voltage shock exposure treatment, and ionizing radiation treatment. In addition, coating treatment with an undercoat agent (such as silicone treatment), primer treatment, matte treatment, crosslinking treatment, or the like may be applied to the base.

The base may be in the form of a single layer or a laminate of two or more layers. In addition, if necessary, known assistants such as a filler, a flame retardant, an anti-deterioration agent, an antistatic agent, a softener, and a plasticizer may be added to the base.

The thickness of the base is not particularly limited, and is preferably 5 to 20 µm, and more preferably 10 to 15 µm. When the thickness of the base is in the above range, the electromagnetic-wave absorbing sheet according to this embodiment can have both strength and flexibility.

### <Magnetic layer>

The magnetic layer used for the electromagnetic-wave absorbing sheet according to this embodiment contains a magnetic material and a binder. The thickness of the magnetic layer is not particularly limited. However, when the magnetic layer is too thin, an electromagnetic-wave absorption property will deteriorate, and when the magnetic layer is too thick, flexibility will decrease. Therefore, the thickness of the magnetic layer is usually set in the range of 5 to 70 µm. In addition, the magnetic layer preferably has a surface electric resistance of 10⁵ Ω/sq. or more. This is because if the surface electric resistance of the magnetic layer is too low, there is a risk of a short circuit occurring when the electromagnetic-wave absorbing sheet is used by being applied to an uneven or curved surface of an electronic device. The surface electric resistance of the magnetic layer is measured using resistivity meter "Hiresta-MCP-HT450" manufactured by Mitsubishi Chemical Analytech, Co., Ltd.

Hereinafter, constituent materials of the magnetic layer will be described.

### [Binder]

Although the binder is not particularly limited and a wide variety of resin-based binders can be used, polyester resins, acrylic resins, polyurethane resins, and the like are preferably used to enhance the flexibility of electromagnetic-wave absorbing sheets. In particular, water-soluble polyester resins that have high water dispersibility and excellent affinity with carbonyl iron are most preferable.

### [Magnetic material]

Any flat carbonyl iron can be used as the magnetic material as long as it forms the magnetic layer together with the binder, such that the full width at half maximum at a peak of the (200) plane of α iron detected by powder X-ray diffraction for the magnetic layer is 0.15 or more and less than 0.40. As a result, it is possible to provide an electromagnetic-wave absorbing sheet having a high transmission attenuation power ratio of 10 dB or more in the 28 GHz millimeter-wave band.

The magnetic material is a soft magnetic material, and thus has a high initial magnetic permeability and can have an electromagnetic-wave absorbing capacity even when the amount of the soft magnetic material added to the magnetic layer is small. Therefore, even when the thickness of the magnetic layer is reduced, an electromagnetic-wave noise suppression effect can be obtained.

In general, flat magnetic powder has higher magnetic anisotropy than spherical magnetic powder, and therefore flat magnetic powder tends to have a high noise suppression effect at high frequencies. In addition, when a high-frequency electromagnetic wave, such as an electromagnetic wave in the millimeter-wave band, enters the soft magnetic material, an alternating current flows through the soft magnetic material. When the soft magnetic material is flattened and its thickness is set to the skin depth of the alternating current or less, the value of the imaginary part of the permeability of the soft magnetic material increases, making it easier to obtain a noise suppression effect.

The magnetic material can be obtained by subjecting raw material powder obtained by thermally decomposing pentacarbonyl iron, represented by Fe(CO)₅, to a milling process (deagglomeration of secondary particles), a classification process (adjustment of particle size distribution), and a reduction treatment process in the stated order to produce reduced carbonyl iron, and then flattening the reduced carbonyl iron.

In general, reduced carbonyl iron has larger crystallite size than non-reduced carbonyl iron, making it easier to flatten compared to non-reduced carbonyl iron. Therefore, when reduced carbonyl iron is subjected to flattening treatment, the crystalline distortion of the carbonyl iron increases. Thus, a further increase in permeability can be expected due to an increase in magnetic anisotropy or shape anisotropy.

The index of the crystallinity of the carbonyl iron can be expressed as the full width at half maximum at a peak of the (200) plane of α iron detected by powder X-ray diffraction. When the full width at half maximum is less than 0.15, the carbonyl iron has not been flattened to a sufficient degree. When the full width at half maximum is 0.40 or more, the flattening treatment has been carried out excessively, and thus flat carbonyl iron may deteriorate. Therefore, when the magnetic layer is formed using the magnetic material together with a binder, flat reduced carbonyl iron is used as the magnetic material, such that the full width at half maximum of the (200) plane of α iron detected by powder X-ray diffraction for the magnetic layer is 0.15 or more and less than 0.40. The full width at half maximum at the peak of the (200) plane of α iron detected by powder X-ray diffraction, which is the index of the crystallinity of the carbonyl iron, varies depending on whether or not the carbonyl iron has been subjected to reduction treatment or the degree of flattening.

The full width at half maximum at the peak of the (200) plane of α iron detected by powder X-ray diffraction is measured as follows. The measuring device used is the X-ray diffraction device "Smart-Lab" manufactured by Rigaku Corporation. The plane direction of the electromagnetic-wave absorbing sheet on the magnetic layer side is used as a measurement surface, and measurements are conducted using a parafocusing optical system. The measurement range is 2θ = 50° to 80°, the scanning speed is 1°/min or less, the sampling interval is 0.01° or less, and continuous measurements are conducted using a constant speed. In the diffraction peak detected through measurement near 2θ = 65°, the peak width at half of the maximum peak intensity value obtained after the background is subtracted is defined as the full width at half maximum.

Flat carbonyl iron powder is used as the magnetic material. Here, in the present application, the flat carbonyl iron powder is defined as carbonyl iron powder having a flatness of 5.0 or more, where the aspect ratio (short side length/thickness) is a ratio of the short side length of the flat carbonyl iron powder to the thickness of the flat carbonyl iron powder, and this aspect ratio is the flatness. Here, assuming that the carbonyl iron powder when viewed from above is in the shape of an ellipse, the short side length of the flat carbonyl iron powder refers to the length of the minor axis of the assumed ellipse. Also, assuming that the carbonyl iron powder is in the shape of a flat ellipsoid, the thickness of the flat carbonyl iron powder refers to the length of an axis perpendicular to the assumed flat ellipsoid, from the intersection of the major and minor axes of the assumed ellipse.

The value of the full width at half maximum of the flat carbonyl iron varies depending on whether the carbonyl iron has been subjected to the reduction treatment and the degree of flattening. Therefore, there is no particular limitation on the thickness of the flat carbonyl iron particles having the full width at half maximum of 0.15 or more and less than 0.40, and usually, carbonyl iron particles with a thickness of 0.1 µm or more and 10 µm or less are used.

Although there is no particular limitation on the maximum diameter of the flat carbonyl iron particles, carbonyl iron particles having a maximum diameter of 100 µm or less are preferable. Here, the term "maximum diameter" refers to the maximum length of the carbonyl iron particles in the longitudinal direction in an image of a cross section of the magnetic layer observed using a scanning electron microscope (SEM). By using carbonyl iron particles with a maximum diameter of 100 µm or less, it is possible to suppress an increase in the surface area of the carbonyl iron particles having low electrical resistance, and thus, the surface electric resistance of the magnetic layer can be greater than 10⁵ Ω/sq. or more.

The thickness and the maximum diameter of the carbonyl iron particles are calculated as the arithmetic mean values of the thickness and maximum diameter of any 100 carbonyl iron particles in the observed image obtained by observing a cross-section of the magnetic layer by SEM.

A content of the magnetic material contained in the magnetic layer is preferably 30% by volume to 70% by volume, and more preferably 50% by volume to 65% by volume. When the above content is lower than 30% by volume, the electromagnetic-wave absorption capacity (noise suppression effect) of the magnetic layer tends to be insufficient. When the content exceeds 70% by volume, the proportion of the binder in the magnetic layer decreases, the adhesion of the magnetic layer to the base decreases, and when the magnetic layer is bent, cracks tend to form and powder tends to fall off, for example, resulting in a decrease in the surface electric resistance of the magnetic layer.

Although the specific gravity of the flat carbonyl iron is not particularly limited, the specific gravity thereof is usually about 7.2.

### <Metal layer>

As shown in FIG. 2, by disposing a metal layer in the electromagnetic-wave absorbing sheet according to this embodiment, the electromagnetic-wave absorbing sheet can have an electric field shielding capacity, and it is possible to suppress not only magnetic noise but also electrical noise. Although the metal layer is disposed between the base and the magnetic layer in FIG. 2, the metal layer may be disposed on an outer surface of the magnetic layer.

There is no particular limitation on the types of metal that constitutes the metal layer as long as it has bending properties and adhesion to the magnetic layer, and aluminum, copper, and the like are preferable. This is because aluminum, copper, and the like are inexpensive, can be easily processed into a thin film, and have excellent bending properties.

There is no particular limitation on thickness of the metal layer. However, when the metal layer is too thick, flexibility will decrease. Therefore, the thickness of the metal layer is usually set in the range of 0.1 to 1 µm.

A metal foil can be used alone as the metal layer, or the metal layer can be formed by forming a metal thin film on the base through vapor deposition or sputtering.

### <Adhesive layer>

When an adhesive layer is disposed on the electromagnetic-wave absorbing sheet according to this embodiment, the thickness of the adhesive layer is preferably 10 to 50 µm, and more preferably 15 to 35 µm. If the above thickness is less than 10 µm, sufficient adhesive force may not be obtained. In addition, if the thickness exceeds 50 µm, the adhesion effect of the adhesive layer will be saturated and an overall thickness of the electromagnetic-wave absorbing sheet will increase, which will reduce flexibility of the electromagnetic-wave absorbing sheet, and thus will reduce conformability when the sheet is applied to an electronic component, or make it difficult to wrap the sheet around a wire or the like.

### (Breaking characteristics of electromagnetic-wave absorbing sheet)

### [Breaking elongation]

It is preferable that the electromagnetic-wave absorbing sheet according to the present application has a breaking elongation of more than 75%, the breaking elongation being specified in JIS (Japanese Industrial Standards) K 7127. When the breaking elongation is greater than 75%, the electromagnetic-wave absorbing sheet according to the present application will have improved conformability to an adherend when the electromagnetic-wave absorbing sheet is used by being applied to an uneven or curved surface of an electronic device. In particular, even when the electromagnetic-wave absorbing sheet according to the present application is used by being wrapped around a cable or a connector, no crack form in the magnetic layer, and the magnetic layer does not peel off from the base. The breaking elongation is more preferably 95% or more, and even more preferably 100% or more. The upper limit of the breaking elongation is not particularly limited, but is usually 150% or less.

### [Breaking stress]

It is preferable that the electromagnetic-wave absorbing sheet according to the present application has a breaking stress of 30 MPa or more, the breaking stress being specified in JIS K 7127. When the breaking stress is 30 MPa or more, the electromagnetic-wave absorbing sheet according to the present application will have improved conformability to an adherend when the electromagnetic-wave absorbing sheet is used by being applied to an uneven or curved surface of an electronic device. In particular, even when the electromagnetic-wave absorbing sheet according to the present application is used by being wrapped around a cable or a connector, no crack form in the magnetic layer, and the magnetic layer does not peel off from the base. The breaking stress is more preferably 35 MPa or more. The upper limit of the breaking stress is not particularly limited, but is usually 70 MPa or less.

It is most preferable that the electromagnetic-wave absorbing sheet according to the present application has a breaking elongation of more than 75%, as specified in JIS K 7127, and has a breaking stress of 30 MPa or more, as specified in JIS K 7127. This can further improve, in particular, both the strength and a wrapping property (conformability) of the electromagnetic-wave absorbing sheet when the electromagnetic-wave absorbing sheet according to the present application is used by being wrapped around a cable or a connector.

The breaking elongation and breaking stress of the electromagnetic-wave absorbing sheet according to this application are measured using the methods specified in JIS K 7127. Specifically, a test piece prepared from the produced electromagnetic-wave absorbing sheet is pulled using a tensile compression tester at a tensile speed of 50 mm/min until the test piece breaks. The breaking elongation is calculated from the elongation when the test piece breaks, by (break displacement / gauge length before tension) × 100. In addition, the breaking stress is calculated from a breaking test force per unit area of a surface at break when the test piece breaks.

### (Method for manufacturing electromagnetic-wave absorbing sheet)

An embodiment of a method for manufacturing the electromagnetic-wave absorbing sheet according to the present application will be described. A method for manufacturing an electromagnetic-wave absorbing sheet according to this embodiment is a method for manufacturing the above-described electromagnetic-wave absorbing sheet of the present application, the method including: a step of subjecting carbonyl iron to reduction treatment; a step of subjecting the reduced carbonyl iron that has been subjected to the reduction treatment to flattening treatment; a step of producing a coating material for forming a magnetic layer by mixing the reduced carbonyl iron that has been subjected to the flattening treatment, a binder, and a solvent together; and a step of applying the coating material for forming a magnetic layer to a base and drying the coating material.

### <Carbonyl iron>

Carbonyl iron before the reduction treatment can be obtained through reaction between raw iron powder and carbon monoxide (CO gas) to synthesize pentacarbonyl iron represented by Fe(CO)₅, which is then thermally decomposed to form raw material powder, which is then subjected to a milling process (deagglomeration of secondary particles) and a classification process (adjustment of particle size distribution) in the stated order.

### <Reduction treatment>

Next, the carbonyl iron obtained above is subjected to reduction treatment to produce reduced carbonyl iron. The reduction treatment is usually performed by hydrogen reduction treatment (hydrogen annealing).

### <Flattening treatment>

Next, the reduced carbonyl iron is subjected to flattening treatment to obtain flat reduced carbonyl iron. Although there is no particular limitation on a specific method for the above flattening treatment, machining using a ball mill, a bead mill, or the like can be applied.

In the flat reduced carbonyl iron produced through the above processes, the full width at half maximum at a peak of the (200) plane of α iron detected by powder X-ray diffraction can be 0.15 or more and less than 0.40. On the other hand, in the case of spherical reduced carbonyl iron, spherical non-reduced carbonyl iron, and flat non-reduced carbonyl iron, it is difficult to achieve a full width at half maximum of 0.15 or more and less than 0.40 at a peak of the (200) plane of α iron detected by powder X-ray diffraction.

### <Coating material for forming magnetic layer>

The coating material for a magnetic layer can be produced by mixing the reduced carbonyl iron that has been subjected to the flattening treatment, a binder, and a solvent together. At this time, by using a water-soluble polyester with excellent coating material properties as a binder, the coating material property of the coating material for forming a magnetic layer can be improved, and the magnetic layer can be easily formed on the base in an ordinary coating process.

It is possible to use, as the solvent, water, ethyl alcohol, methyl alcohol, n-propyl alcohol, isopropyl alcohol, n-butyl alcohol, isobutyl alcohol, ethylene glycol, propylene glycol, and the like.

The content of the solvent is not particularly limited, and may be 50.0% by mass or more and 99.5% by mass or less, relative to the total mass of the coating material for forming a magnetic layer.

Further, a surface conditioner, a defoaming agent, a thickening agent, and the like may be added to the coating material for forming a magnetic layer.

### <Formation of magnetic layer>

It is possible to use, as a method for applying the coating material for forming a magnetic layer onto the base, for example, a coating method such as bar coating, reverse coating, gravure coating, Microgravure (registered trademark) coating, die coating, dipping, spin coating, slit coating, or spray coating.

It is sufficient that the drying after the coating material is applied may be carried out under conditions in which a solvent component of the coating material for forming a magnetic layer is evaporated, and is preferably carried out at 100°C to 150°C for 5 to 60 minutes. If the solvent remains in the magnetic layer, the strength tends to decrease. Examples of the drying method include a hot air drying method, a heat drying method, a vacuum drying method, and an air drying method.

### Examples

Hereinafter, the present application will be described in detail using examples. However, the present application is not limited to the following examples. In the following description, "parts" means "parts by mass", unless otherwise specified.

### (Example 1)

### <Preparation of coating material for forming magnetic layer>

A coating material for forming a magnetic layer was prepared by mixing and dispersing the following components.
(1) Magnetic material (flat reduced carbonyl iron powder, product name "RPZ" manufactured by Jiangsu Tianyi Ultrafine Metal Powder Limited Company): 37.6 parts
(2) Binder (water-soluble polyester resin solution, product name "PLAS COAT Z-3310" manufactured by Goo Chemical, Co., Ltd., solid content concentration: 25.0% by mass, solvent: water): 9.6 parts
(3) Binder (water-soluble polyester resin solution, product name "PLAS COAT Z-760" manufactured by Goo Chemical, Co., Ltd., solid content concentration: 25.0% by mass, solvent: water): 9.6 parts
(4) Cross-linking agent (oxazoline group-containing water-soluble polymer, product name "EPOCROS WS-500" manufactured by Nippon Shokubai Co., Ltd.): 4.0 parts
(5) Thickening agent (water-based rheology additive, product name "LAPONITE-RD" manufactured by BYK): 1.0 part
(6) Solvent (n-propyl alcohol): 10.0 parts
(7) Pure water: 28.2 parts

A content of the magnetic material in the coating material for forming a magnetic layer was 60% by volume relative to the total solid content of the coating material for forming a magnetic layer.

### <Formation of magnetic layer>

Next, a PET film with a thickness of 12 µm (product name "ESTER Film E5100" manufactured by Toyobo, Co., Ltd.) was used as the base, and the coating material for forming a magnetic layer was applied to one of the main surfaces of the base using a bar coater, and then dried at 120°C for 5 minutes, thereby producing an electromagnetic-wave absorbing sheet of Example 1 in which the magnetic layer was formed on one main surface. The thickness of the magnetic layer was 64 µm.

### (Example 2)

Spherical reduced carbonyl iron powder (product name "RZE") manufactured by Jiangsu Tianyi Ultrafine Metal Powder Limited Company, a crushing ball (zirconia ball ø5 mm), and a solvent (ethanol) were added to a wet ball mill, and flattening treatment was performed for 2 hours. The shape of the flattened powder after drying was observed using an optical microscope, and the flattened carbonyl iron powder having a major axis of 10 µm or more was prepared as flat reduced carbonyl iron powder.

An electromagnetic-wave absorbing sheet of Example 2 was produced in the same manner as in Example 1, except that the magnetic material was changed to the flat reduced carbonyl iron powder prepared, and the thickness of the magnetic layer was changed to 68 µm.

### (Example 3)

An electromagnetic-wave absorbing sheet of Example 3 was produced in the same manner as in Example 1, except that the content of the magnetic material was changed to 40% by volume of the total solid content of the coating material for forming a magnetic layer and the thickness of the magnetic layer was changed to 56 µm.

### (Example 4)

### <Preparation of coating material for forming magnetic layer>

The following components were added to a batch-type kneader, and the mixture was kneaded at a rotation speed of 35 rpm while the mixture was cooled with cold water to prevent an increase in temperature, to produce a magnetic material-containing compound.
(1) Magnetic material (flat reduced carbonyl iron powder, product name "RPZ" manufactured by Jiangsu Tianyi Ultrafine Metal Powder Limited Company): 88.3 parts
(2) Binder (silicone rubber, product name "KE-951KU" manufactured by Shin-Etsu Chemical Co., Ltd.): 11.7 parts

Next, the produced magnetic material-containing compound was added to a planetary mixer together with toluene (solvent) and dissolved to prepare a coating material for forming a magnetic layer. The content of the magnetic material in the coating material for forming a magnetic layer was 60% by volume relative to the total solid content of the coating material for forming a magnetic layer.

### <Formation of magnetic layer>

Next, a PET film with a thickness of 12 µm (product name "ESTER Film E5100" manufactured by Toyobo, Co., Ltd.) was used as the base, and the coating material for forming a magnetic layer was applied to one of the main surfaces of the base using a comma coater, followed by electron beam crosslinking to produce an electromagnetic-wave absorbing sheet of Example 4 in which the magnetic layer was formed on one main surface. The thickness of the magnetic layer was 64 µm.

### (Example 5)

### <Preparation of coating material for forming magnetic layer>

The following components were added to a batch-type kneader, and the mixture was kneaded at a rotation speed of 35 rpm while the mixture was cooled with cold water to prevent an increase in temperature, to produce a magnetic material-containing compound.
(1) Magnetic material (flat reduced carbonyl iron powder, product name "RPZ" manufactured by Jiangsu Tianyi Ultrafine Metal Powder Limited Company): 80.0 parts
(2) Binder (acrylic rubber, product name "AR-51" manufactured by Zeon Corporation): 20.0 parts

An electromagnetic-wave absorbing sheet of Example 5 was produced in the same manner as in Example 4, except that the magnetic material-containing compound was used, the content of the magnetic material was changed to 40% by volume relative to the total solid content of the coating material for forming a magnetic layer, and the thickness of the magnetic layer was changed to 100 µm.

### (Comparative Example 1)

An electromagnetic-wave absorbing sheet of Comparative Example 1 was produced in the same manner as in Example 1, except that the magnetic material was changed to spherical reduced carbonyl iron powder (product name "RZE") manufactured by Jiangsu Tianyi Ultrafine Metal Powder Limited Company, and the thickness of the magnetic layer was changed to 63 µm.

### (Comparative Example 2)

An electromagnetic-wave absorbing sheet of Comparative Example 2 was produced in the same manner as in Example 1, except that the magnetic material was changed to spherical non-reduced carbonyl iron powder (product name "YW3") manufactured by Jiangsu Tianyi Ultrafine Metal Powder Limited Company, and the thickness of the magnetic layer was changed to 45 µm.

### (Comparative Example 3)

An electromagnetic-wave absorbing sheet of Comparative Example 3 was produced in the same manner as in Example 1, except that the magnetic material was changed to flat non-reduced carbonyl iron powder (product name "YP") manufactured by Jiangsu Tianyi Ultrafine Metal Powder Limited Company, and the thickness of the magnetic layer was changed to 41 µm.

### (Comparative Example 4)

Flat reduced carbonyl iron powder (product name "RPZ") manufactured by Jiangsu Tianyi Ultrafine Metal Powder Limited Company, a crushing ball (zirconia ball ø5 mm), and a solvent (ethanol) were added to a wet ball mill and flattening treatment was performed for 10 hours. The shape of the flattened powder after drying was observed using an optical microscope, and the flat reduced carbonyl iron powder having a major axis of 10 µm or more was prepared as flat reduced carbonyl iron powder.

An electromagnetic-wave absorbing sheet of Comparative Example 4 was produced in the same manner as in Example 1, except that the magnetic material was changed to the flat reduced carbonyl iron powder prepared.

For the produced electromagnetic-wave absorbing sheets of Examples 1 to 5 and Comparative Examples 1 to 4, the full width at half maximum at a peak of the (200) plane of α iron detected in the powder X-ray diffraction for the magnetic layer, the surface electric resistance of the magnetic layer, the transmission attenuation power ratio (Rtp) at 28 GHz, breaking elongation, and breaking stress were measured.

### <Full width at half maximum>

The full width at half maximum at the peak of the (200) plane of α iron detected by powder X-ray diffraction for the magnetic layer was measured using the X-ray diffraction device "Smart-Lab" manufactured by Rigaku Corporation, as mentioned before.

### <Surface electric resistance>

As described above, the surface electric resistance of the magnetic layer was measured using resistivity meter "Hiresta-MCP-HT450" manufactured by Mitsubishi Chemical Analytech, Co., Ltd.

### <Transmission attenuation power ratio>

The magnetic noise suppression effect of the produced electromagnetic-wave absorbing sheet was evaluated by measuring the transmission attenuation power ratio (Rtp) at 28 GHz using the microstripline method. Specifically, the transmission attenuation power ratio of the electromagnetic-wave absorbing sheet at 28 GHz was measured using a near-field noise suppression sheet evaluation system available from Keycom, which complies with the measurement system (Rtp measurement system) of IEC No.: IEC62333-1 and IEC62333-2.

### <Breaking elongation and breaking stress>

The breaking elongation and breaking stress of the electromagnetic-wave absorbing sheets produced were measured using the method specified in JIS K 7127. Specifically, a test piece prepared from the electromagnetic-wave absorbing sheet produced was pulled using a tensile compression tester "Technograph" manufactured by MinebeaMitsumi Inc. at a tensile speed of 50 mm/min until the test piece broke. The breaking elongation was calculated from the elongation when the test piece broke, by (breaking displacement / gauge length before tension) × 100. In addition, the breaking stress was calculated from a breaking test force per unit area of a breaking surface when the test piece broke.

The above results are shown in Tables 1 and 2, along with the types of the magnetic materials used in the magnetic layers of the produced electromagnetic-wave absorbing sheets, characteristics thereof, the thickness of the magnetic layers, the content of the magnetic materials, and the types of binder.

**[Table 1]**

| | Ex. 1 | Ex. 2 | Ex. 3 | Ex. 4 | Ex. 5 |
|---|---|---|---|---|---|
| Magnetic Material | Carbonyl Iron | Carbonyl Iron | Carbonyl Iron | Carbonyl Iron | Carbonyl Iron |
| Shape | Flat | Flat | Flat | Flat | Flat |
| Reduction | Yes | Yes | Yes | Yes | Yes |
| Thickness of Magnetic Layer (µm) | 64 | 68 | 56 | 64 | 100 |
| Magnetic Material Content (% by volume) | 60 | 60 | 40 | 60 | 40 |
| Binder | Water-Soluble Polyester | Water-Soluble Polyester | Water-Soluble Polyester | Silicone Rubber | Acrylic Rubber |
| Full Width at Half Max. | 0.31 | 0.17 | 0.31 | 0.31 | 0.31 |
| Surface Electric Resistance (Ω/sq.) | 1.3×10⁶ | 2.5×10⁶ | 2.2×10⁶ | 1.3×10⁶ | 1.3×10⁶ |
| Rtp [dB]/28 GHz | 11.4 | 10.5 | 12.3 | 11.4 | 11.4 |
| Breaking Elongation (%) | 114 | 98 | 114 | 75 | 10 |
| Breaking Stress (MPa) | 46.9 | 36.6 | 40.6 | 5.0 | 17.2 |

**[Table 2]**

| | Comp. Ex. 1 | Comp. Ex. 2 | Comp. Ex. 3 | Comp. Ex. 4 |
|---|---|---|---|---|
| Magnetic Material | Carbonyl Iron | Carbonyl Iron | Carbonyl Iron | Carbonyl Iron |
| Shape | Spherical | Spherical | Flat | Flat |
| Reduction | Yes | No | No | Yes |
| Thickness of Magnetic Layer (µm) | 63 | 45 | 41 | 64 |
| Magnetic Material Content (% by volume) | 60 | 60 | 60 | 60 |
| Binder | Water-Soluble Polyester | Water-Soluble Polyester | Water-Soluble Polyester | Water-Soluble Polyester |
| Full Width at Half Max. | 0.07 | 1.48 | 2.25 | 0.50 |
| Surface Electric Resistance (Ω/sq.) | 2.8×10¹⁰ | 8.2×10¹¹ | 1.9×10¹¹ | 2.5×10⁸ |
| Rtp [dB]/28 GHz | 5.7 | 3.4 | 6.3 | 8.0 |
| Breaking Elongation (%) | 98 | 96 | 97 | 114 |
| Breaking Stress (MPa) | 37.9 | 34.7 | 31.1 | 46.9 |

As can be seen from Table 1, in the electromagnetic-wave absorbing sheet of Examples 1 to 5, the half width at the peak of the α iron (200) plane detected in the powder X-ray diffraction for the magnetic layer was 0.15 or more and less than 0.40, and the transmission attenuation power ratio (Rtp) was 10 dB or more at 28 GHz, and a high magnetic noise suppression effect was observed.

Also, the electromagnetic-wave absorbing sheets of Examples 1 to 3, in which a water-soluble polyester was used as the binder, had an elastic elongation of more than 75%, and an elastic stress of 30 MPa or more. On the other hand, the electromagnetic-wave absorbing sheet of Example 4, in which silicone rubber was used as the binder, and the electromagnetic-wave absorbing sheet of Example 5, in which acrylic rubber was used as the binder, had an elastic elongation of 75% or less and an elastic stress of less than 30 MPa. Thus, when the electromagnetic-wave absorbing sheets were each wrapped around a stainless steel mandrel with a diameter of 3 mm conforming to JIS K 5600-5-1, it was possible to wrap the electromagnetic-wave absorbing sheets of Examples 1 to 3 around the mandrel without any problems, but the electromagnetic-wave absorbing sheets of Examples 4 and 5 had a small elastic elongation, which caused breakage within the sheets, and had a small breaking stress, which made it difficult to wrap the sheet around the mandrel.

On the other hand, in Comparative Example 1, because spherical reduced carbonyl iron that was not been subjected to the flattening treatment was used, the full width at half maximum was as low as 0.07 and the transmission attenuation power ratio was as low as 5.7 dB. In Comparative Example 2, because spherical non-reduced carbonyl iron was used, the full width at half maximum was 1.48, which was a value of 0.4 or more, and the transmission attenuation power ratio was as low as 3.4 dB possibly due to the absence of flattening treatment. Furthermore, in Comparative Example 3, because flat non-reduced carbonyl iron was used, the full width at half maximum was 2.25, which was a value of 0.4 or more, and the transmission attenuation power ratio was as low as 6.3 dB possibly due to excessive flattening treatment on the non-reduced carbonyl iron. Furthermore, in Comparative Example 4, the full width at half maximum was 0.50, which was a value of 0.4 or more, and thus the transmission attenuation power ratio was as low as 8.0 dB. This shows that, even with flat reduced carbonyl iron, the noise suppression effect decreases when the full width at half maximum is outside the range of 0.15 to 0.40.

With regard to the embodiments of the present application including Examples 1 to 5 described above, the following supplementary embodiments will be disclosed.
(Supplementary Embodiment 1) An electromagnetic-wave absorbing sheet comprising:
   a base; and
   a magnetic layer,
   wherein the magnetic layer contains a magnetic material and a binder,
   the magnetic material contains flat carbonyl iron, and
   a full width at half maximum at a peak of the (200) plane of α iron detected by powder X-ray diffraction for the magnetic layer is 0.15 or more and less than 0.40.
(Supplementary Embodiment 2) The electromagnetic-wave absorbing sheet according to Supplementary Embodiment 1,
   wherein breaking elongation specified in JIS K 7127 is greater than 75%.
(Supplementary Embodiment 3) The electromagnetic-wave absorbing sheet according to Supplementary Embodiment 1,
   wherein breaking elongation specified in JIS K 7127 is 95% or more.
(Supplementary Embodiment 4) The electromagnetic-wave absorbing sheet according to any one of Supplementary Embodiments 1 to 3,
   wherein breaking stress specified in JIS K 7127 is 30 MPa or more.
(Supplementary Embodiment 5) The electromagnetic-wave absorbing sheet according to any one of Supplementary Embodiments 1 to 3,
   wherein breaking stress specified in JIS K 7127 is 35 MPa or more.
(Supplementary Embodiment 6) The electromagnetic-wave absorbing sheet according to any one of Supplementary Embodiments 1 to 5,
   wherein the flat carbonyl iron is reduced carbonyl iron.
(Supplementary Embodiment 7) The electromagnetic-wave absorbing sheet according to any one of Supplementary Embodiments 1 to 6,
   wherein a content of the magnetic material contained in the magnetic layer is 30% by volume to 70% by volume.
(Supplementary Embodiment 8) The electromagnetic-wave absorbing sheet according to any one of Supplementary Embodiments 1 to 6,
   wherein a content of the magnetic material contained in the magnetic layer is 50% by volume to 65% by volume.
(Supplementary Embodiment 9) The electromagnetic-wave absorbing sheet according to any one of Supplementary Embodiments 1 to 8,
   wherein the binder contains a water-soluble polyester resin.
(Supplementary Embodiment 10) The electromagnetic-wave absorbing sheet according to any one of Supplementary Embodiments 1 to 9,
   wherein the base is a resin film.
(Supplementary Embodiment 11) The electromagnetic-wave absorbing sheet according to any one of Supplementary Embodiments 1 to 10,
   wherein the magnetic layer has a surface electric resistance of 10⁵ Ω/sq. or more.
(Supplementary Embodiment 12) The electromagnetic-wave absorbing sheet according to any one of Supplementary Embodiments 1 to 11, further comprising:
   a metal layer.
(Supplementary Embodiment 13) The electromagnetic-wave absorbing sheet according to any one of Supplementary Embodiments 1 to 12,
   wherein the electromagnetic-wave absorbing sheet has an overall thickness of 20 to 1000 µm.
(Supplementary Embodiment 14) A method for manufacturing the electromagnetic-wave absorbing sheet according to any one of Supplementary Embodiments 1 to 13, the method comprising:
   a step of subjecting carbonyl iron to reduction treatment;
   a step of subjecting the reduced carbonyl iron that has been subjected to the reduction treatment to flattening treatment;
   a step of producing a coating material for forming a magnetic layer by mixing the reduced carbonyl iron that has been subjected to the flattening treatment, a binder, and a solvent together; and
   a step of applying the coating material for forming a magnetic layer to a base and drying the coating material.
(Supplementary Embodiment 15) The method for manufacturing the electromagnetic-wave absorbing sheet according to Supplementary Embodiment 14,
   wherein the reduction treatment is hydrogen reduction treatment.

The invention may be embodied in forms other than the embodiments described above. The embodiments disclosed in this application are merely examples and the present invention is not limited to these embodiments. The scope of the present application should be construed in view of the appended claims, rather than the foregoing description, and all changes that come within the meaning and range of equivalency of the claims are intended to be embraced therein.

### Description of Reference Numerals

- 10, 10': Electromagnetic-wave absorbing sheet
- 11: Base
- 12: Magnetic layer
- 13: Metal layer

## Claims

1. An electromagnetic-wave absorbing sheet comprising:
a base; and
a magnetic layer,
wherein the magnetic layer contains a magnetic material and a binder,
the magnetic material contains flat carbonyl iron, and
a full width at half maximum at a peak of the (200) plane of α iron detected by powder X-ray diffraction for the magnetic layer is 0.15 or more and less than 0.40.

2. The electromagnetic-wave absorbing sheet according to claim 1,
wherein breaking elongation specified in JIS K 7127 is greater than 75%.

3. The electromagnetic-wave absorbing sheet according to claim 1,
wherein breaking stress specified in JIS K 7127 is 30 MPa or more.

4. The electromagnetic-wave absorbing sheet according to claim 1,
wherein the flat carbonyl iron is reduced carbonyl iron.

5. The electromagnetic-wave absorbing sheet according to claim 1,
wherein a content of the magnetic material contained in the magnetic layer is 30% by volume to 70% by volume.

6. The electromagnetic-wave absorbing sheet according to claim 1,
wherein the binder contains a water-soluble polyester resin.

7. The electromagnetic-wave absorbing sheet according to claim 1,
wherein the base is a resin film.

8. The electromagnetic-wave absorbing sheet according to claim 1,
wherein the magnetic layer has a surface electric resistance of 10⁵ Ω/sq. or more.

9. The electromagnetic-wave absorbing sheet according to claim 1, further comprising:
a metal layer.

10. The electromagnetic-wave absorbing sheet according to claim 1,
wherein the electromagnetic-wave absorbing sheet has an overall thickness of 20 to 1000 µm.

11. A method for manufacturing the electromagnetic-wave absorbing sheet according to any one of claims 1 to 10, the method comprising:
a step of subjecting carbonyl iron to reduction treatment;
a step of subjecting the reduced carbonyl iron that has been subjected to the reduction treatment to flattening treatment;
a step of producing a coating material for forming a magnetic layer by mixing the reduced carbonyl iron that has been subjected to the flattening treatment, a binder, and a solvent together; and
a step of applying the coating material for forming a magnetic layer to a base and drying the coating material.

12. The method for manufacturing the electromagnetic-wave absorbing sheet according to claim 11,
wherein the reduction treatment is hydrogen reduction treatment.
